Europäisches Patentamt

**European Patent Office**

**Office européen des brevets**

(11) Veröffentlichungsnummer: **0 188 752**
A2

(12) **EUROPÄISCHE PATENTANMELDUNG**

(21) Anmeldenummer: 85116037.4

(22) Anmeldetag: 16.12.85

(51) Int. Cl.⁴: **C 08 G 59/17**, C 08 G 59/12, C 08 G 59/42, G 03 F 7/10

(30) Priorität: 24.12.84 DE 3447355

(43) Veröffentlichungstag der Anmeldung: **30.07.86** Patentblatt 86/31

(84) Benannte Vertragsstaaten: **BE CH DE FR GB IT LI NL**

(71) Anmelder: **BASF Aktiengesellschaft, Carl-Bosch-Strasse 38, D-6700 Ludwigshafen (DE)**

(72) Erfinder: **Schornick, Gunnar, Dr., Konrad-Adenauer-Strasse 8, D-6719 Neuleiningen (DE)**
Erfinder: **Elzer, Albert, Dr., Pappelstrasse 4, D-6701 Otterstadt (DE)**
Erfinder: **Hofmann, Reiner, Dr., Mandelbergstrasse 44, D-6730 Neustadt (DE)**

(54) **Vernetzbares Harz, lichtempfindliches Aufzeichnungsmaterial auf Basis dieses vernetzbaren Harzes sowie Verfahren zur Herstellung einer Flachdruckplatte mittels dieses lichtempfindlichen Aufzeichnungsmaterials.**

(57) Die Erfindung betrifft nach einem speziellen Verfahren herzustellende, durch Polymerisation vernetzbare, in wäßrig-alkalischen Lösungen lösliche oder zumindest dispergierbare, oligomere Harze mit vorzugsweise mehr als 2 (Meth)acryloyl-Gruppen sowie freien Carboxyl-Gruppen. Die Erfindung betrifft des weiteren lichtempfindliche, photopolymerisierbare und vernetzbare Aufzeichnungsmaterialien für die optische Informationsfixierung auf Basis dieser oligomeren Harze sowie ein Verfahren zur Herstellung von Flachdruckplatten mittels der erfindungsgemäßen lichtempfindlichen Aufzeichnungsmaterialien.

Vernetzbares Harz, lichtempfindliches Aufzeichnungsmaterial auf Basis
dieses vernetzbaren Harzes sowie Verfahren zur Herstellung einer Flachdruckplatte mittels dieses lichtempfindlichen Aufzeichnungsmaterials

Die Erfindung betrifft vernetzbare, oligomere, urethangruppenfreie Harze
mit (Meth)acryloyl-Gruppen und freien Carboxylgruppen, die in wäßrig-alkalischen Medien löslich oder zumindest dispergierbar sind, sowie des
weiteren lichtempfindliche, photopolymerisierbare Zusammensetzungen bzw.
Aufzeichnungsmaterialien, z.B. für die Herstellung von Schutz- und Überzugsschichten und insbesondere zur Anwendung bei der optischen Informationsfixierung, die ein solches vernetzbares, oligomeres Harz enthalten.
Die Erfindung bezieht sich weiterhin auf ein Verfahren zur Herstellung
von Flachdruckplatten mittels der in Rede stehenden lichtempfindlichen,
photopolymerisierbaren Aufzeichnungsmaterialien, welches unter Einsatz
von rein wäßrig-alkalischen Entwicklerlösungen durchgeführt werden kann.

Mit wäßrig-alkalischen Entwicklermedien auswaschbare, lichtempfindliche,
photopolymerisierbare Aufzeichnungsmaterialien für die Herstellung beispielsweise von bildmäßig strukturierten Schutz- und Überzugsschichten
und photopolymeren Druckformen, insbesondere Flachdruckplatten, sind bekannt. Sie enthalten im allgemeinen auf einem dimensionsstabilen Träger,
beispielsweise einer Kunststoff-Folie oder einem Metallsubstrat wie einem
Aluminiumblech, eine photopolymerisierbare Aufzeichnungsschicht aus einer
Mischung von mindestens einem in wäßrig-alkalischen Medien löslichen oder
dispergierbaren polymeren Bindemittel, mindestens einem ethylenisch ungesättigten, photopolymerisierbaren Monomeren, mindestens einem Photoinitiator sowie gegebenenfalls weiteren Zusatz- und/oder Hilfsstoffen. Als
polymere Bindemittel für die wäßrig-alkalisch entwickelbaren, photopolymerisierbaren Aufzeichnungsschichten sind dabei insbesondere Carboxyl-
Gruppen oder Carbonsäureanhydrid-Gruppen enthaltende Polymere vorgeschlagen worden, wie z.B. Alkyl(meth)acrylat/(Meth)acrylsäure-Copolymerisate,
Styrol/Maleinsäureanhydrid-Copolymerisate oder Styrol/Maleinsäurehalbester-Copolymerisate (vgl. unter anderem DE-A-19 15 571, DE-B-20 27 467,
DE-B-20 64 080 und DE-A-22 05 146).

Diese bekannten, wäßrig-alkalisch entwickelbaren, photopolymerisierbaren
Aufzeichnungsmaterialien erfordern in aller Regel recht lange Belichtungszeiten, beispielsweise um die im Offset-Druck als Standard geltenden
feinen Bildelemente (z.B. Tonwerte unter 2 % bei einem Raster von
60 L/cm) korrekt abzubilden und dauerhaft auf dem Schichtträger zu verankern. Häufig ist auch das Auflösungsvermögen dieser Aufzeichnungsmaterialien noch unbefriedigend und bedarf es wegen der großen Sauerstoff-
Rss/ro

empfindlichkeit einer Schutz- und Sperrschicht auf der photopolymerisierbaren Aufzeichnungsschicht. Ein weiterer Nachteil ist die Empfindlichkeit der photopolymerisierten Schichten gegenüber dem Auswaschmedium, d.h. die Überwaschempfindlichkeit ist groß, als auch läßt die Beständigkeit der photopolymerisierten Schichten gegenüber wäßrigen oder organischen Lösungsmitteln und anderen Chemikalien, mit denen die photopolymerisierten Schichten bei ihrer Anwendung in Berührung kommen, zu wünschen übrig.

In der DE-A-27 36 058 wird ein Trockenfilmresist beschrieben, der rein wäßrig-alkalisch entwickelbar ist und gleichzeitig im belichteten Zustand eine gute chemische Beständigkeit aufweisen soll. Die photopolymerisierbare Schicht des Trockenfilmresists enthält dabei ein carboxylgruppenhaltiges, wasserunlösliches Copolymerisat als Bindemittel, ein polares Oligomeres, welches durch Anlagerung einer ungesättigten Mono- oder Dicarbonsäure, wie z.B. (Meth)acrylsäure, Maleinsäure oder Fumarsäure, an ein Epoxidharz erhalten worden ist, sowie ein polyfunktionelles (Meth)acrylat-Monomeres. Das Gewichtsverhältnis von polymerem Bindemittel zu Oligomeren zu Monomeren in der photopolymerisierbaren Schicht beträgt 1:0,15-1:0,15-1. Auch diese photopolymerisierbaren Aufzeichnungsmaterialien sind hinsichtlich ihrer anwendungstechnischen Eigenschaften noch nicht zufriedenstellend.

In der DE-A-24 42 527 sowie der DE-C-25 57 408 werden lichthärtbare, für die Entwicklung mit wäßrig-alkalischen Medien geeignete Zusammensetzungen beschrieben, die ein photopolymerisierbares und vernetzbares, Acryloyl- und/oder Methacryloyl-Gruppen und freie Carboxylgruppen enthaltendes, oligomeres Harz enthalten. Diese lichthärtbaren Zusammensetzungen besitzen eine gute Haftung gegenüber metallischen Trägern, sind vergleichsweise schnell härtend und sauerstoffunempfindlich. Auch diese bekannten Materialien sind für den Einsatz bei der optischen Informationsfixierung, wie beispielsweise der Herstellung von Resistschichten sowie insbesondere auch von Flachdruckplatten, noch nicht völlig zufriedenstellend. So sind die in diesen Druckschriften beschriebenen lichtempfindlichen Zusammensetzungen häufig klebrig, so daß sie mit einer Schutz- und Deckfolie versehen sein müssen. Insbesondere ist auch die Beständigkeit der aus diesen lichthärtbaren Aufzeichnungsmaterialien hergestellten bildmäßig strukturierten Schichten, wie z.B. der hieraus hergestellten Flachdruckplatten, gegenüber Chemikalien und wäßrigen und organischen Lösungsmitteln, mit denen sie bei ihrer Verwendung in Berührung kommen, vielfach noch ungenügend.

Aufgabe der vorliegenden Erfindung war es, ein neues, photopolymerisierbares und vernetzbares Harz aufzuzeigen, welches sich mit Vorteil für den Einsatz in wäßrig-alkalisch entwickelbaren, lichtempfindlichen Aufzeichnungsmaterialien für die Herstellung von dünnen Schutz- und Überzugsschichten und insbesondere von Flachdruckplatten hoher Qualität und Beständigkeit eignet. Aufgabe der Erfindung war es weiterhin, ein Verfahren
zur Herstellung von Flachdruckplatten mittels wäßrig-entwickelbaren, photopolymerisierbaren Aufzeichnungsmaterialien aufzuzeigen, welches sich
einfach und schnell durchführen läßt und zu dauerhaften und beständigen
Flachdruckplatten mit exakter Bild- und Tonwertwiedergabe führt.

Es wurde nun gefunden, daß diese Aufgabe durch lichtempfindliche, photopolymerisierbare Zusammensetzungen gelöst wird, die als photopolymerisierbare Komponente ein vernetzbares, in wäßrig-alkalischen Lösungen lösliches oder zumindest dispergierbares, oligomeres, urethangruppenfreies
Harz mit Acryloyl- und/oder Methacryloyl-Gruppen und freien Carboxyl-
gruppen der nachfolgend näher beschriebenen Art enthalten.

Gegenstand der Erfindung ist demzufolge ein photopolymerisierbares und
vernetzbares, in wäßrig-alkalischen Lösungen lösliches oder zumindest
dispergierbares, Acryloyl- und/oder Methacryloyl-Gruppen sowie freie
Carboxylgruppen enthaltendes, oligomeres Harz mit einem mittleren Molekulargewicht (Zahlenmittel) im Bereich von etwa 1000 bis 10.000 und einer
Säurezahl im Bereich von 50 bis 150 mg KOH/g, wie es erhältlich ist durch
Umsetzung einer eine oder mehrere (Meth)acryloyl-Gruppen enthaltenden
Diol- oder Polyol-Verbindung mit mehrfunktionellen Carbonsäuren oder deren Derivaten, insbesonderen cyclischen Carbonsäureanhydriden, unter Ausbildung von sauren Teilestern der Carbonsäuren bzw. Carbonsäure-Derivate
und anschließende kettenverlängernde Umsetzung eines Teils der freien
Carboxyl-Gruppen des so erhaltenen Reaktionsproduktes mit einem Di- und/
oder Polyepoxid.

Gegenstand der Erfindung ist weiterhin ein lichtempfindliches Aufzeichnungsmaterial aus einer homogenen, in wäßrig-alkalischen Lösungen löslichen oder zumindest dispergierbaren Mischung, enthaltend mindestens einen
Photopolymerisationsinitiator sowie mindestens ein photopolymerisierbares
und vernetzbares Acryloyl- und/oder (Meth)acryloyl-Gruppen sowie freie
Carboxyl-Gruppen enthaltendes oligomeres Harz mit einem mittleren Molekulargewicht (Zahlenmittel) im Bereich von etwa 1000 bis 10.000 und einer
Säurezahl im Bereich von 50 bis 150 mg KOH/g sowie gegebenenfalls weitere
Zusatz- und/oder Hilfsstoffe, welches dadurch gekennzeichnet ist, daß als
photopolymerisierbares und vernetzbares Harz ein in den wäßrig-alkalischen Lösungen lösliches oder zumindest dispergierbares, oligomeres Harz
enthalten ist, wie es erhältlich ist durch Umsetzung einer eine oder
mehrere (Meth)acryloyl-Gruppen enthaltenden Diol- oder Polyol-Verbindung mit mehrfunktionellen Carbonsäuren oder deren Derivaten, insbesondere cyclischen Carbonsäureanhydriden, unter Ausbildung von sauren Teilestern der Carbonsäuren bzw. Carbonsäurederivate und anschließende kettenverlängernde Umsetzung eines Teils der freien Carboxylgruppen des so erhaltenen Reaktionsproduktes mit einem Di- und/oder Polyepoxid.

Gegenstand der Erfindung ist weiterhin ein Verfahren zur Herstellung einer Flachdruckplatte, bei dem ein lichtempfindliches Aufzeichnungselement mit einem für Flachdruckplatten typischen Träger mit hydrophiler Oberfläche und einer darauf aufgebrachten, etwa 0,5 bis 6 $\mu$m dicken, photopoly-merisierbaren Aufzeichnungsschicht bildmäßig mit aktinischem Licht belichtet wird und anschließend die nicht belichteten Bereiche der Aufzeichnungsschicht mittels einer wäßrig-alkalischen Entwicklerlösung entfernt werden, wobei die photopolymerisierbare Aufzeichnungsschicht mindestens einen Photopolymerisationsinitiator und als Hauptbestandteil mindestens ein photopolymerisierbares, vernetzbares, Acryloyl- und/oder Methacryloyl-Gruppen sowie freie Carboxyl-Gruppen enthaltendes oligomeres Harz und ferner gegebenenfalls weitere Zusatz- und/oder Hilfsstoffe enthält. Das erfindungsgemäße Verfahren ist dadurch gekennzeichnet, daß die photopolymerisierbare Aufzeichnungsschicht des lichtempfindlichen Aufzeichnungselementes gebildet wird aus einer homogenen Mischung von mindestens 60 Gew.%, bezogen auf die photopolymerisierbare Aufzeichnungsschicht, mindestens eines photopolymerisierbaren und vernetzbaren, in den wäßrig-alkalischen Entwicklerlösungen löslichen oder zumindest dispergierbaren oligomeren Harzes mit einem mittleren Molekulargewicht (Zahlenmittel) im Bereich von etwa 1000 bis 10.000 und einer Säurezahl im Bereich von 50 bis 150 mg KOH/g, 0,001 bis 10 Gew.%, bezogen auf die photo-polymerisierbare Aufzeichnungsschicht, mindestens eines Photopolymerisa-tionsinitiators sowie 0 bis 39,9 Gew.%, bezogen auf die photopolymeri-sierbare Aufzeichnungsschicht, an weiteren Zusatz- und/oder Hilfsstoffen, und daß in dieser Mischung solche photopolymerisierbaren und vernetzbaren, oligomeren Harze enthalten sind, wie sie erhältlich sind durch Umsetzung einer eine oder mehrere (Meth)acryloyl-Gruppen enthaltenden Diol- oder Polyol-Verbindung mit mehrfunktionellen Carbonsäuren oder deren Derivaten, insbesondere cyclischen Carbonsäureanhydriden, unter Ausbildung von sauren Teilestern der Carbonsäuren bzw. Carbonsäurederivate und anschließende kettenverlängernde Umsetzung eines Teils der freien Carboxylgruppen des so erhaltenen Reaktionsprodukts mit einem Di- und/ oder Polyepoxid.

Bei den erfindungsgemäßen, durch Polymerisation vernetzbaren Harzen handelt es sich um Oligomere, d.h. um Verbindungen, die mindestens 2, vorzugsweise aber mehr, wiederkehrende Struktureinheiten in einem Molekül enthalten. Das mittlere Molekulargewicht (Zahlenmittel) dieser oligomeren Harze liegt im Bereich von etwa 1000 bis 10.000, vorzugsweise im Bereich von etwa 1500 bis 6000. Bevorzugte erfindungsgemäße oligomere Harze sind bei Raumtemperatur fest. Die erfindungsgemäßen oligomeren Harze sollen durch Polymerisation, insbesondere durch die photoinitiierte Polymerisation, vernetzbar sein und enthalten dementsprechend im allgemeinen im Mittel mindestens 2, vorzugsweise jedoch mehr als 2, Acryloyl- und/oder Methacryloyl-Gruppen im Molekül eingebaut. Der Gehalt an acrylischen und/oder methacrylischen Doppelbindungen in den erfindungsgemäßen oligomeren Harzen liegt vorteilhafterweise im Mittel im Bereich von etwa 2,1 bis 8, insbesondere im Bereich von etwa 2,5 bis 6, Acryloyl- und/oder Metharcyloyl-Gruppen pro Molekül des oligomeren Harzes. Die erfindungsgemäßen, vernetzbaren, oligomeren Harze sollen in wäßrig-alkalischen Lösungen, wie sie insbesondere zur Entwicklung von bildmäßig belichteten, photopolymerisierbaren Aufzeichnungsmaterialien eingesetzt werden, löslich oder zumindest dispergierbar sein und sind - im Hinblick auf ihre Verarbeitbarkeit - vorteilhafter Weise auch in organischen Lösungsmitteln, wie z.B. Ketonen, Estern, niederen Alkanolen oder ähnlichen, löslich. Die Löslichkeit bzw. Dispergierbarkeit der erfindungsgemäßen vernetzbaren oligomeren Harze wird im wesentlichen durch deren Gehalt an freien Carboxyl-Gruppen bestimmt. Die erfindungsgemäßen vernetzbaren, oligomeren Harze enthalten dabei so viel freie Carboxyl-Gruppen, daß ihre Säurezahl im Bereich von etwa 50 bis 150 mg KOH/g, vorzugsweise von 60 bis 120 mg KOH/g, liegt.

Bei den erfindungsgemäßen, photopolymerisierbaren und vernetzbaren oligomeren Harzen handelt es sich um urethangruppenfreie Harze, wie sie erhältlich sind und erhalten werden durch Umsetzung von einer eine oder mehrere Acryloyl- und/oder Methacryloyl-Gruppen enthaltenden Diol- oder Polyol-Verbindung mit mehrfunktionellen Carbonsäuren oder deren Derivaten, insbesondere cyclischen Carbonsäureanhydriden, unter Ausbildung von sauren Teilestern der Carbonsäuren bzw. Carbonsäurederivate und anschließende kettenverlängernde Umsetzung eines Teils der freien Carboxylgruppen des so erhaltenen Reaktionsproduktes mit einem Di- und/oder Polyepoxid.

Als Ausgangsverbindung für die Herstellung der erfindungsgemäßen, durch Polymerisation vernetzbaren, oligomeren Harze können grundsätzlich beliebige, urethangruppenfreie Diole oder Polyole eingesetzt werden, die eine oder mehr Acryloyl- und/oder Methacryloyl-Gruppen im Molekül eingebaut enthalten. Als besonders günstig haben sich hierbei solche Acryloyl- und/oder Methacryloyl-Gruppen enthaltenden Diole und/oder Polyole erwiesen, wie sie durch Umsetzung von Acrylsäure und/oder Methacrylsäure mit Diepoxiden oder Polyepoxiden oder mit OH-Gruppen tragenden Monoepoxiden erhalten werden. Bei der Umsetzung der (Meth)acrylsäure mit den Epoxid-Verbindungen werden die Glycidyl-Grupen der Epoxid-Verbindungen in $\beta$-Hydroxy(meth)acrylsäureestergruppen überführt. Bei der Umsetzung von Hydroxylgruppen tragenden Monoepoxiden mit Acrylsäure und/oder Methacrylsäure entstehen so Diol- oder Polyol-Verbindungen, die eine Acryloyl- oder eine Methacryloyl-Gruppe enthalten. Als Beispiel für OH-Gruppen tragende Epoxide sei das Glyidol genannt. Bei der Umsetzung von Di- oder Polyepoxiden mit Acrylsäure und/oder Methacrylsäure entstehen dementsprechend Diole oder Polyole, die zwei oder mehr Acryloyl- und/oder Methacryloyl-Gruppen eingebaut enthalten. Als Di- und Polyepoxide kommen hierbei Verbindungen mit zwei oder mehr Glycidyl-Gruppen in Betracht, wie Di- oder Polyglycidylether mehrwertiger Alkohole und insbesondere mehrwertiger Phenole und Di- oder Polyglycidylester mehrwertiger aliphatischer, cycloaliphatischer und insbesondere aromatischer Carbonsäuren. Dabei sind für die Herstellung der Acryloyl- und/oder Methacryloyl-Gruppen enthaltenden Diol- oder Polyol-Verbindungen solche Diepoxide und/oder Polyepoxide besonders bevorzugt, bei denen die Glycidyl-Gruppen direkt oder indirekt an ein- oder mehrkernige, gegebenenfalls substituierte aromatische Ringsysteme gebunden sind. Als Beispiele für geeignete und vorteilhafte Glycidylether seien die Umsetzungsprodukte von Epichlorhydrin mit Bisphenol A oder mit Derivaten bzw. Substitutionsprodukten von Bisphenol A genannt. Zu den geeigneten Glycidylestern gehören unter anderem Phthalsäurediglycidylester, Isophthalsäurediglycidylester, Terephthalsäurediglycidylester und Hexahydrophthalsäurediglycidylester. Die genannten Di- und Polyepoxide können vor oder während der Umsetzung mit der Acrylsäure und/oder Methacrylsäure auch noch durch Umsetzung mit aliphatischen oder aromatischen Dicarbonsäuren bzw. gegenüber Glycidyl-Gruppen reaktiven aliphatischen oder aromatischen Dicarbonsäure-Derivaten kettenverlängert werden. Zu diesem Zweck kommen beispielsweise Phthalsäure, Isophthalsäure, Terephthalsäure, Hexahydrophthalsäure, Malonsäure, Bernsteinsäure, Methylbernsteinsäure, Adipinsäure bzw. die gegenüber Glycidylgruppen reaktiven Derivate dieser Säuren in Betracht, wobei Phthalsäure und Adipinsäure bzw. deren Derivate bevorzugt sind. Die, gegebenenfalls vorverlängerten, Di- und/oder Polyepoxide werden mit der Acrylsäure und/ oder Methacrylsäure in einem solchen Verhältnis miteinander umgesetzt, daß zumindest der überwiegende Anteil der Glycidylgruppen mit der (Meth)acrylsäure in $\beta$-Hydroxy(meth)acrylsäureester-Gruppen überführt wird. Dementsprechend ist bei dieser Umsetzung das Äquivalentverhältnis Glycidyl-Gruppen : COOH-Gruppen vorzugsweise im Bereich von 1:0,5 bis etwa 1:1 und liegt insbesondere bei etwa 1:1. Wird die Vorverlängerung der Di- bzw. Polyepoxide mit den Dicarbonsäuren bzw. deren Derivaten gleichzeitig mit der Umsetzung der Di- oder Polyepoxide mit der Acrylsäure und/oder Methacrylsäure vorgenommen, d.h. werden die Di- oder Polyepoxide mit einem Gemisch aus Dicarbonsäure bzw. Dicarbonsäure-Derivat der genannten Art und Acryl- und/oder Methacrylsäure umgesetzt, liegt das Äquivalentverhältnis Glycidyl-Gruppen : Gesamt-COOH-Gruppen ebenfalls vorzugsweise bei etwa 1:1, wobei dann in dem Gemisch aus Dicarbonsäure bzw. Dicarbonsäurederivat und Acryl- und/oder Methacrylsäure der Anteil der Dicarbonsäuren bzw. Dicarbonsäure-Derivaten und der Anteil der Acrylsäure und/oder Methacrylsäure jeweils im Bereich von etwa 30 bis 70 Mol.%, bezogen auf das Gemisch der in Rede stehenden Carbonsäuren bzw. deren Derivate, liegt.

Als vorteilhaft für die Herstellung der erfindungsgemäßen, durch Polymerisation vernetzbaren oligomeren Harze haben sich dabei beispielsweise solche Acryloyl- und/oder Methacryloyl-Gruppen enthaltenden Diol- und Polyol-Verbindungen erwiesen, die durch Umsetzung von Bisphenol A-diglycidylethern, insbesondere dem Diglycidylether aus Bisphenol A und Epichlorhydrin, mit Acrylsäure im Äquivalentverhältnis Glycidyl-Gruppen : COOH-Gruppen von etwa 1:1 oder durch Umsetzung von Bisphenol A-diglycidylethern, insbesondere dem durch Umsetzung von Epichlorhydrin mit Bisphenol A erhaltenen Diglycidylether, mit einem Gemisch aus Adipinsäure und Acrylsäure in einem Äquivalentverhältnis Glycidyl-Gruppen : COOH-Gruppen der Adipinsäure : COOH-Gruppen der Acrylsäure von 1:0,4-0,6:0,4-0,6 bei einem Äquivalentverhältnis Glycidyl-Gruppen : Gesamt-COOH-Gruppen von etwa 1:1 hergestellt worden sind.

Diese Acryloyl- und/oder Methacryloyl-Gruppen enthaltenden Diol- oder Polyol-Verbindungen werden zur Einführung von freien Carboxylgruppen mit mehrfachen Carbonsäuren bzw. deren Derivaten, insbesondere cyclischen Carbonsäureanhydriden, vorzugsweise mit Dicarbonsäuren bzw. deren Derivaten und speziell cyclischen Dicarbonsäureanhydriden, in einer solchen Weise umgesetzt, daß die Hydroxylgruppen der Diol- bzw. Polyol-Verbindungen mit den mehrfachen Carbonsäuren bzw. deren Derivaten unter Bildung von sauren Teilestern dieser Carbonsäuren reagieren. Sofern die Acryloyl- und/oder Methacryloyl-Gruppen enthaltenden Diol- bzw. Polyol-Verbindungen von ihrer Herstellung her auch noch Glycidyl-Gruppen enthalten, werden auch diese mit den mehrfachen Carbonsäuren bzw. deren Derivaten umgesetzt. Vorzugsweise wird die Reaktion so geführt, daß alle Hydroxylgruppen sowie gegebenenfalls noch in der Diol- oder Polyol-Verbindung enthaltenen Glycidyl-Gruppen mit den mehrfachen Carbonsäuren bzw. deren Derivaten unter Bildung der sauren Teilester umgesetzt werden. Als mehrfache Carbonsäuren bzw. Derivate hiervon für diese Reaktion kommen insbesondere Dicarbonsäuren und cyclische Anhydride von Di-, Tri- oder Tetracarbonsäuren in Betracht, wie z.B. Phthalsäure, Isophthalsäure, Terephthalsäure, Trimellithsäure, Hexahydrophthalsäure, Malonsäure, Bernsteinsäure, Adipinsäure und andere sowie deren Anhydride, vorzugsweise die
cyclischen Anhydride dieser Carbonsäuren. Als besonders vorteilhaft haben
sich hier die mehrfachen aromatischen Carbonsäuren und insbesondere deren
cyclische Anhydride erwiesen, wie z.B. Phthalsäureanhydrid oder Mischungen von Phthalsäureanhydrid mit anderen mehrfachen Carbonsäuren oder Carbonsäureanhydriden, insbesondere Mischungen von Phthalsäureanhydrid mit
Trimellithsäureanhydrid. In den Mischungen von Phthalsäureanhydrid mit
den anderen mehrfachen Carbonsäuren bzw. Carbonsäureanhydriden liegt das
Mischungsverhältnis vorzugsweise im Bereich von etwa 65 bis 95 Mol.%,
insbesondere 75 bis 90 Mol.%, an Phthalsäureanhydrid und etwa 5 bis
35 Mol.%, insbesondere 10 bis 25 Mol.%, der anderen mehrfachen Carbonsäuren bzw. Carbonsäureanhydride. Bei der Umsetzung der die Acryloyl- und/
oder Methacryloyl-Gruppen enthaltenden Diol- und/oder Polyol-Verbindungen
mit den cyclischen Carbonsäureanhydriden liegt das Äquivalentverhältnis
OH-Gruppen : Anhydrid-Gruppen vorzugsweise im Bereich von etwa 1:0,8 bis
1:1,2.

Die bei der Teilveresterung der mehrfachen Carbonsäuren bzw. der mehrfachen Carbonsäurederivate mit den Acryloyl- und/oder Methacryloyl-Gruppen
enthaltenden Diol- und/oder Polyol-Verbindungen gebildeten freien Carboxyl-Gruppen werden anschließend teilweise mit Diepoxiden und/oder Polyepoxiden unter Kettenverlängerung sowie gegebenenfalls Verzweigung zu den
oligomeren Harzen, umgesetzt. Als Diepoxide und Polyepoxide für die Kettenverlängerung sowie gegebenenfalls Verzweigung können grundsätzlich
alle Verbindungen mit zwei oder mehr Glycidyl-Gruppen verwendet werden,
wie beispielsweise die Umsetzungsprodukte von Epichlorhydrin mit Diolen
oder Polyolen, die Umsetzungsprodukte von Epichlorhydrin mit Diaminen
oder Polyaminen, Polyolefinepoxide, Epoxiharze vom Novolak-Typ sowie Glycidylester von Di- oder Polycarbonsäuren. So kommen gleichermaßen Di-
oder Polyglycidylether von aliphatischen Diolen oder Polyolen, wie beispielsweise von Butandiol, Glycerin, Trimethylolpropan, Pentaerythrit
oder Polyethylenglykolen, wie auch Di- oder Polyglycidylether von ein-
oder mehrkernigen aromatischen Di- oder Polyhydroxyverbindungen, wie z.B.
von mehrwertigen Phenolen, sowie weiterhin die Di- oder Polyglycidylester
aliphatischer, cycloaliphatischer oder aromatischer Di- oder Polycarbonsäuren, wie z.B. von Adipinsäure, Hexahydrophthalsäure, Phthalsäure, Isophthalsäure oder Terephthalsäure in Betracht. Als besonders vorteilhaft
haben sich hier die Di- oder Polyglycidylether aliphatischer Di- oder
Polyole, wie z.B. Pentaerythrittriglycidylether, sowie die Diglycidylether von Bisphenol A oder den Substitutionsprodukten von Bisphenol A,
wie z.B. der durch Umsetzung von Epichlorhydrin mit Bisphenol A erhaltene
Diglycidylether, erwiesen. Bei der kettenverlängernden Umsetzung der freien Carboxylgruppen des zuvor erzeugten Reaktionsproduktes mit den Di- und/oder Polyepoxiden liegt das Äquivalentverhältnis COOH-Gruppen : Glycidyl-Gruppen über 1:1, vorzugsweise im Bereich von etwa 1:0,8 bis 1:0,2 und insbesondere im Bereich von etwa 1:0,6 bis etwa 1:0,25.

Die Herstellung der erfindungsgemäßen, durch Polymerisation vernetzbaren oligomeren Harze kann nach den üblichen und an sich bekannten Verfahrensweisen für Polykondensations- bzw. Polyadditionsreaktionen in Substanz oder vorteilhafterweise in Lösung, gegebenenfalls in Gegenwart geeigneter Katalysatoren, erfolgen. Die Reaktionen werden dabei im Hinblick auf eine gute Verarbeitbarkeit der oligomeren Harze vorzugsweise so geführt, daß die resultierenden oligomeren Harze in organischen Lösungsmitteln löslich sind.

Als besonders vorteilhaft haben sich solche erfindungsgemäßen oligomeren Harze erwiesen, die wie folgt erhalten worden sind: Umsetzung des Diglycidylethers, erhalten durch Reaktion von Epichlorhydrin mit Bisphenol A, mit (Meth)acrylsäure bzw. einem Gemisch aus (Meth)-acrylsäure und einer Dicarbonsäure, insbesondere Adipinsäure oder Phthalsäure, im Äquivalentverhältnis Glycidyl-Gruppen : Gesamt-COOH-Gruppen von etwa 1:1, wobei bei Einsatz von Carbonsäuregemischen das Verhältnis von (Meth)acrylsäure zu der Dicarbonsäure in den weiter oben angegebenen Grenzen liegt, Umsetzung der Hydroxyl-Gruppen des so erhaltenen Reaktionsprodukts mit Phthalsäureanhydrid oder einer Mischung aus einer überwiegenden Menge an Phthalsäureanhydrid und einer untergeordneten Menge an Trimellithsäureanhydrid im Äquivalentverhältnis OH-Gruppen : Anhydrid-Gruppen von etwa 1:1 unter Bildung der sauren Teilester der Phthalsäure sowie der gegebenenfalls mitverwendeten Trimellithsäure sowie anschließende Umsetzung eines Teils der freien Carboxyl-Gruppen des so erhaltenen Reaktionsproduktes mit einem Di- oder Triglycidylether, insbesondere dem Diglycidylether aus Epichlorhydrin mit Bisphenol A oder auch z.B. Pentaerythrittriglycidylether, im Äquivalentverhältnis COOH-Gruppen : Glycidyl-Gruppen von etwa 2-4:1.

Die erfindungsgemäßen, vernetzbaren oligomeren Harze eignen sich beispielsweise für die Herstellung von lichtempfindlichen, photopolymerisierbaren Zusammensetzungen ganz allgemein, wie sie unter anderem für die Herstellung von Überzügen und dergleichen eingesetzt werden. Aufgrund ihrer besonders vorteilhaften Eigenschaften sind die erfindungsgemäßen, vernetzbaren oligomeren Harze insbesondere für die Herstellung von lichtempfindlichen, photopolymerisierbaren, wäßrig-alkalisch entwickelbaren Aufzeichnungsmaterialien geeignet, wie sie beispielsweise für die Herstellung von bildmäßig strukturierten Schutz- und Überzugsschichten sowie insbesondere auch zur Herstellung von Flachdruckplatten eingesetzt werden. Die lichtempfindlichen Aufzeichnungsmaterialien auf Basis der erfindungsgemäßen, vernetzbaren oligomeren Harze besitzen nicht nur sowohl im unbelichteten als auch im belichteten Zustand eine gute Haftung gegenüber metallischen Trägermaterialien, sondern ebenso eine hohe Photoreaktivität und vergleichsweise große Sauerstoffunempfindlichkeit. Im Vergleich zu bekannten lichtempfindlichen, photopolymerisierbaren Aufzeichnungsmaterialien auf Basis ähnlich aufgebauter, vernetzbarer oligomerer Harze besitzen die lichtempfindlichen Aufzeichnungsmaterialien gemäß der Erfindung überraschenderweise insbesondere eine geringere Klebrigkeit, so daß lichtempfindliche Aufzeichnungselemente auf Basis dieser Harze ohne Deckschicht oder Deckfolie auf der photopolymerisierbaren Aufzeichnungsschicht verwendet werden können. Nicht zu erwarten stand neben den guten Belichtungs- und Entwicklungseigenschaften der mit den erfindungsgemäßen vernetzbaren oligomeren Harzen hergestellten photopolymerisierbaren Aufzeichnungsmaterialien die hohe Beständigkeit der mit diesen Aufzeichnungsmaterialien hergestellten bildmäßig strukturierten photopolymeren Überzugs- und Schutzschichten sowie auch Flachdruckplatten, insbesondere gegenüber wäßrigen und organischen Lösungsmitteln oder anderen Chemikalien, mit denen diese Überzugs- und Schutzschichten bzw. Flachdruckplatten bei ihrer Verwendung in Berührung kommen.

Die lichtempfindlichen, photopolymerisierbaren Zusammensetzungen, einschließlich der lichtempfindlichen, photopolymerisierbaren Aufzeichnungsmaterialien, auf Basis der erfindungsgemäßen, vernetzbaren oligomeren Harze enthalten in homogener Mischung mit den erfindungsgemäßen, vernetzbaren oligomeren Harzen mindestens einen Photopolymerisationsinitiator sowie gegebenenfalls weitere Zusatz- und/oder Hilfsstoffe, wobei die Zusatzstoffe gleichermaßen photopolymerisierbar und/oder auch nicht photopolymerisierbar sein können. In diesen photopolymerisierbaren Zusammensetzungen können die erfindungsgemäßen, vernetzbaren oligomeren Harze allein oder auch in Mischung miteinander eingesetzt werden. Die erfindungsgemäßen lichtempfindlichen photopolymerisierbaren Aufzeichnungsmaterialien sollen dabei auch in wäßrig-alkalischen Lösungen löslich oder zumindest dispergierbar sein und sind für ihre Anwendung im allgemeinen in Form einer dünnen photopolymerisierbaren, vernetzbaren Schicht auf einen geeigneten, dimensionsstabilen Träger aufgebracht. In den lichtempfindlichen Aufzeichnungsmaterialien sind darüber hinaus die einzelnen Komponenten so aufeinander abgestimmt, daß sie miteinander verträglich sind und keine, zumindest keine nennenswerte, Lichtstreuung bei der bildmäßigen Belichtung der Aufzeichnungsmaterialien bewirken.

Als Photopolymerisationsinitiatoren für die erfindungsgemäßen photopolymerisierbaren, vernetzbaren Zusammensetzungen bzw. Aufzeichnungsmaterialien kommen die für solche Zusammensetzungen und lichtempfindliche Aufzeichnungsmaterialien an sich bekannten und üblichen Photoinitiatoren
bzw. Photoinitiatorsysteme in Betracht. Dazu gehören Benzoin und Benzoinderivate, wie Benzoinether; substituierte Benzoine und substituierte
Benzoinderivate, z.B. substituierte Benzoinether, Benzile, insbesondere
Benzilketale, wie z.B. Benzildimethylketal, Benzilmethylethylketal oder
Benzilmethylbenzylketal; und die als Photoinitiatoren bekannten und wirksamen Benzoyldiarylphosphinoxide, wie z.B. 2,4,6-Trimethylbenzoyldiphenylphosphinoxid. Besonders vorteilhaft als Photoinitiatoren, insbesondere
für dünne lichtempfindliche, photopolymerisierbare Aufzeichnungsschichten, wie sie beispielsweise für die Herstellung von Resistmustern und
Flachdruckplatten eingesetzt werden, sind unter anderem Verbindungen vom
Typ des Benzophenons und seiner Derivate, wie Benzophenon, 4,4'-Dimethyl-
aminobenzophenon, 4,4'-Diethylaminobenzophenon, Derivate von Michlers
Keton, 4,4'-Dichlorbenzophenon etc., sowie deren Gemische, insbesondere
Mischungen aus Benzophenon und Michlers Keton; Hexaarylbisimidazole, wie
z.B. 2,2'-o-Chlorphenyl-4,4', 5,5'-p-methoxyphenyl-bisimidazol, oder Gemische aus Hexaarylbisimidazolen mit Sensibilisierungsmitteln, wie z.B.
2-Mercaptobenzochinazol; mehrkernige unsubstituierte oder substituierte
Chinone, wie Anthrachinon, Benzanthrachinon, 2-Ethylanthrachinon oder
tert.-Butylanthrachinon; 2-Chlorthioxanthon sowie die als Photoinitiatoren wirksamen Acridin- oder Phenazin-Derivate. Typische Beispiele für
Photoinitiatorsysteme sind Kombinationen aus Benzophenon oder Benzophenon-Derivaten mit tertiären Aminen, wie Triethanolamin oder Michlers-
Keton, oder Gemische aus Hexaarylbisimidazolen und den Leukobasen von
Triphenylmethanfarbstoffen, wie z.B. Leucokristallviolett, Leucomalachitgrün oder Tris-(4-diethylamino-2-methylphenyl)-methan. Die Photoinitiatoren bzw. Photoinitiatorsysteme sind in der einschlägigen Literatur
hinreichend beschrieben, ihre Auswahl ist dem Fachmann geläufig. Die Photoinitiatoren bzw. Photoinitiator-Systeme können in den erfindungsgemäßen
photopolymerisierbaren, vernetzbaren Zusammensetzungen bzw. Aufzeichnungsmaterialien allein oder in Mischung miteinander eingesetzt werden.

Neben den erfindungsgemäßen vernetzbaren oligomeren Harzen sowie den Photoinitiatoren können die lichtempfindlichen, photopolymerisierbaren und
vernetzbaren Zusammensetzungen bzw. Aufzeichnungsmaterialien gemäß der
Erfindung weitere Zusatz- und/oder Hilfsstoffe in wirksamen Mengen enthalten.

So können beispielsweise neben den erfindungsgemäßen, vernetzbaren oligomeren Harzen sowie den Photoinitiatoren auch noch ein oder mehrere, ethylenisch ungesättigte, photopolymerisierbare Monomere enthalten sein. Durch den Zusatz solcher photopolymerisierbarer Monomeren können insbesondere die Belichtungseigenschaften der photopolymerisierbaren, vernetzbaren Zusammensetzungen bzw. Aufzeichnungsmaterialien variiert werden, wobei bei Zusatz von Monomeren im allgemeinen mit kürzeren Belichtungszeiten gearbeitet werden kann. Die ethylenisch ungesättigten, photopolymerisierbaren Monomeren können dabei sowohl mono- als auch polyfunktionell sein, d.h. sie können eine oder mehrere photopolymerisierbare Doppelbindungen besitzen. Vorzugsweise werden für die erfindungsgemäßen, photopolymerisierbaren und vernetzbaren Zusammensetzungen bzw. Aufzeichnungsmaterialien bi- oder mehrfunktionelle ethylenisch ungesättigte, photopolymerisierbare Monomere allein, in Mischung miteinander oder Mischungen hiervon mit monofunktionellen ethylenisch ungesättigten, photopolymerisierbaren Monomeren eingesetzt. Diese Monomeren, die üblicherweise einen Siedepunkt bei Atmosphärendruck von über 100°C und ein Molekulargewicht im allgemeinen unter 1000 aufweisen, sollen für die lichtempfindlichen Aufzeichnungsmaterialien mit den erfindungsgemäßen vernetzbaren, oligomeren Harzen verträglich sein. Vorzugsweise werden solche Monomeren verwendet, die mindestens eine endständige Vinyl- oder Vinyliden-Doppelbindung aufweisen und insbesondere solche, bei denen die photopolymerisierbare Doppelbindung bzw. die photopolymerisierbaren Doppelbindungen durch Konjugation oder Nachbarschaftsstellung zu O-, N- oder S-Atomen aktiviert sind.

Als Vertreter für die ethylenisch ungesättigten, photopolymerisierbaren Monomeren seien neben den Allylverbindungen, wie z.B. Allylacrylat und Diallylphthalat, und Vinylverbindungen, wie z.B. den N-Vinyllactamen, insbesondere N-Vinylpyrrolidon und N-Vinylcaprolactam, die Acryloyl- und/oder Methacryloyl-Gruppen enthaltenden Monomeren genannt. Hierzu gehören insbesondere die Ester der Acrylsäure und Methacrylsäure, wie z.B. die Di- und Tri-(meth)acrylate von Ethylenglykol, Diethylenglykol, Triethylenglykol oder Polyethylenglykolen mit einem Molekulargewicht bis etwa 500, 1,2-Propandiol, 1,3-Propandiol, Propylenglykolen mit einem Molekulargewicht bis etwa 500, 1,4-Butandiol, 1,1,1-Trimethylolpropan, 2,2-Dimethylpropandiol, Glycerin oder Pentaerythrit; Pentaerythrittetra-(meth)-acrylat, Glykosetetra-(meth)acrylat; Urethanacrylate und -methacrylate mit zwei oder mehr Acryloyl- bzw. Methacryloyl-Gruppen, wie sie beispielsweise durch Umsetzung von aliphatischen Diolen oder Polyolen der vorstehend genannten Art mit organischen Diisocyanaten, z.B. Hexamethylendiisocyanat, im Äquivalentverhältnis OH:NCO von etwa 1:2 und anschließende Umsetzung der freien Isocyanatgruppen des erhaltenen Reaktionsprodukts mit Monohydroxy-(meth)acrylaten, insbesondere Monohydroxyalkyl-(meth)acrylaten hergestellt werden können; Monomere mit zwei oder

BASF Aktiengesellschaft - 13 - O.Z. 0050/37510  0188752

mehr Acryloyl- oder Methacryloyl-Gruppen, wie sie durch Umsetzung von Acrylsäure und/oder Methacrylsäure mit Di- und Polyglycidylverbindungen, insbesondere Di- oder Polyglycidylethern, entstehen, wie z.B. das Umsetzungsprodukt aus zwei Mol Acrylsäure und/oder Methacrylsäure mit einem Mol Bisphenol A-bisglycidylether. Als Beispiel für monofunktionelle Monomere seien die Monoacrylate und Monomethacrylate von Monoalkanolen, insbesondere mit 1 bis 20 C-Atomen, oder die Mono(meth)acrylate der oben genannten Diole und Polyole erwähnt. Zu den besonders bevorzugten Monomeren gehören unter anderem Trimethylolpropantriacrylat, Trimethylolpropantrimethacrylat, Pentaerythrittri- und -tetraacrylat sowie Pentaerythrittri- und -tetramethacrylat.

Als weitere Zusatz- und/oder Hilfsstoffe, die neben den erfindungsgemäßen, vernetzbaren oligomeren Harzen, den Photopolymerisationsinitiatoren sowie gegebenenfalls den photopolymerisierbaren Monomeren in den erfindungsgemäßen lichtempfindlichen, photopolymerisierbaren und vernetzbaren Zusammensetzungen bzw. Aufzeichnungsmaterialien enthalten sein können, kommen sowohl nicht polymerisierbare, die Belichtungs- und/oder Polymerisationseigenschaften beeinflussende Zusatz- und/oder Hilfsstoffe, wie z.B. Farbstoffe, Pigmente, sensitometrische Regler, thermische Polymerisationsinhibitoren und ähnliche, als auch die mechanischen Eigenschaften verbessernde oder modifizierende Zusatzstoffe, wie beispielsweise Weichmacher, Füllstoffe, Verlaufshilfsmittel, polymere Bindemittel etc., in Betracht. Für diese weiteren Zusatz- und/oder Hilfsstoffe, die in den erfindungsgemäßen lichtempfindlichen, photopolymerisierbaren und vernetzbaren Zusammensetzungen bzw. Aufzeichnungsmaterialien enthalten sein können, kommen die in der einschlägigen Literatur hierfür beschriebenen und an sich bekannten und üblichen Verbindungen in Betracht. Beispiele für Farbstoffe und/oder Pigmente, die sowohl als Kontrastmittel als auch schichtverfestigend wirken können, sind unter anderem in den US-Patentschriften 3 218 167 und 3 884 693 beschrieben. Hierzu gehören beispielsweise Victoria-Reinblau FGA, Victoria-Reinblau BO (C.I. 42595), Malachitgrün, Kristallviolett, Victoria-Blau B (C.I. 44045), Rhodamin 6 G (C.I. 45160) und andere. Zur Erhöhung des Bildkontrastes nach der bildmäßigen Belichtung können beispielsweise Farbstoffe wie Methanilgelb (C.I. 13065), Methylorange (C.I. 13025) oder Phenylazodiphenylamin verwendet werden, aber auch die Leukobasen der Triarylmethan-Farbstoffe, wie z.B. Malachitgrün-Leukobase, Kristallviolett-Leukobase, oder auch Rhodamin B-Base. Zu den geeigneten thermischen Polymerisationsinhibitoren gehören unter anderem Hydrochinon, Hydrochinon-Derivate, 2,6-Di-tert.-butyl-p-kresol, Nitrophenole, N-Nitrosoamine, wie N-Nitrosodiphenylamin oder die Salze des N-Nitrosocyclohexylhydroxylamins. Sensitometrische Regler für die Aufzeichnungsmaterialien sind unter anderem Verbindungen wie z.B. 9-Nitroanthracen, 10,10'-Bisanthrone, Phenazinium-, Phenoxazinium-, Acridinium- oder Phenothiazinium-Farbstoffe, insbesondere in Kombination mit milden Reduktionsmitteln, 1,3-Dinitrobenzole und ähnliche. Gegebenenfalls in den lichtempfindlichen, photopolymerisierbaren und vernetzbaren Aufzeichnungsmaterialien enthaltene Weichmacher, Verlaufshilfsmittel und/ oder polymere Bindemittel sollen mit den übrigen Bestandteilen der lichtempfindlichen Aufzeichnungsmaterialien, insbesondere den erfindungsgemäßen, vernetzbaren oligomeren Harzen sowie gegebenenfalls mitverwendeten ethylenisch ungesättigten, photopolymerisierbaren Monomeren, verträglich sein. Für die erfindungsgemäßen, wäßrig-alkalisch entwickelbaren lichtempfindlichen Aufzeichnungsmaterialien sind dabei solche polymeren Bindemittel von besonderem Vorteil, die in Wasser unlöslich, in wäßrig-alkalischen Lösungen jedoch löslich oder zumindest dispergierbar sind, weshalb sich hierfür insbesondere solche verträglichen polymeren Bindemittel eignen, die freie Säuregruppen oder Carbonsäureanhydrid-Gruppen, insbesondere freie Carboxyl-Gruppen und/oder Carbonsäureanhydrid-Gruppen, eingebaut enthalten. Als Beispiele für geeignete und sehr vorteilhafte polymere Bindemittel seien freie Carboxyl-Gruppen enthaltende N-Vinylamid-Copolymerisate genannt, wie z.B. die in Wasser unlöslichen, in wäßrig-alkalischen Lösungen jedoch löslichen oder zumindest dispergierbaren Copolymerisate aus 10 bis 50 Gew.%, vorzugsweise 20 bis 45 Gew.%, N-Vinylpyrrolidon und/oder N-Vinylcaprolactam, 5 bis 30 Gew.%, vorzugsweise 5 bis 15 Gew.%, Acrylsäure und/oder Methacrylsäure sowie 30 bis 80 Gew.%, insbesondere 40 bis 70 Gew.%, mindestens eines hydrophoben Comonomeren, wie z.B. Styrol und/oder Alkyl(meth)acrylaten, wie z.B. Methylmethacrylat, oder auch Vinylacetat, wobei sich die angegebenen Gewichtsprozente jeweils auf das Copolymerisat beziehen.

Die erfindungsgemäßen photopolymerisierbaren, vernetzbaren Zusammensetzungen bzw. Aufzeichnungsmaterialien enthalten im allgemeinen 0,001 bis 10 Gew.%, insbesondere 0,1 bis 5 Gew.%, an Photopolymerisationsinitiatoren. Die Art und Menge der gegebenenfalls neben den erfindungsgemäßen, vernetzbaren oligomeren Harzen und den Photoinitiatoren zusätzlich noch mit enthaltenen Zusatz- und/oder Hilfsstoffe kann in weiten Grenzen variiert werden und hängt im wesentlichen von dem gewünschten Eigenschaftsbild sowie insbesondere auch dem vorgesehenen Verwendungszweck dieser photopolymerisierbaren und vernetzbaren Zusammensetzungen bzw. Aufzeichnungsmaterialien ab. Im allgemeinen soll dabei jedoch der Anteil der erfindungsgemäßen vernetzbaren oligomeren Harze nicht unter 5 Gew.%, vorzugsweise nicht unter 20 Gew.%, bezogen auf die gesamte photopolymerisierbare, vernetzbare Mischung der Zusammensetzungen bzw. des Aufzeichnungsmaterials, liegen. Üblicherweise bilden das oder die erfindungsgemäße(n), vernetzbare(n) oligomere(n) Harz(e) mengenmäßig den größten Be-

0188752

standteil der erfindungsgemäßen photopolymerisierbaren und vernetzbaren Zusammensetzungen bzw. Aufzeichnungsmaterialien. Die erfindungsgemäßen lichtempfindlichen, photopolymerisierbaren und vernetzbaren Zusammensetzungen bzw. Aufzeichnungsmaterialien eignen sich dabei insbesondere für die Herstellung von relativ dünnen Schutz- und Überzugsschichten, vorzugsweise mit einer Dicke unter 100 $\mu$m.

In einer besonders günstiger, bevorzugten Ausführungsform, insbesondere für die Herstellung von Flachdruckplatten, bestehen die erfindungsgemäßen lichtempfindlichen Aufzeichnungsmaterialien aus einer homogenen, in wäßrig-alkalischen Lösungen löslichen oder zumindest dispergierbaren Mischung von mindestens 60 Gew.%, vorzugsweise mindestens 65 Gew.%, bezogen auf das lichtempfindliche Aufzeichnungsmaterial, mindestens eines erfindungsgemäßen, vernetzbaren, oligomeren Harzes, 0,001 bis 10 Gew.%, vorzugsweise 0,1 bis 5 Gew.%, bezogen auf das lichtempfindliche Aufzeichnungsmaterial, mindestens eines Photopolymerisationsinitiators sowie 0 bis 39,9 Gew.%, bezogen auf das lichtempfindliche Aufzeichnungsmaterial, insgesamt an weiteren photopolymerisierbaren und/oder nicht photopolymerisierbaren Zusatz- und/oder Hilfsstoffen in wirksamen Mengen. Sind solche weiteren Zusatz-und/oder Hilfsstoffe in diesen bevorzugten lichtempfindlichen Aufzeichnungsmaterialien enthalten, liegt ihr Anteil üblicherweise nicht unter 0,01 Gew.%, bezogen auf das lichtempfindliche Aufzeichnungsmaterial; vorzugsweise beträgt der Gesamtanteil an Zusatzund/oder Hilfsstoffen, die neben den erfindungsgemäßen vernetzbaren, oligomeren Harzen und den Photopolymerisationsinitiatoren in den lichtempfindlichen Aufzeichnungsmaterialien enthalten sind, nicht mehr als 29,9 Gew.%, bezogen auf das lichtempfindliche Aufzeichnungsmaterial. Die obere Grenze für den Gehalt an den erfindungsgemäßen vernetzbaren, oligomeren Harzen in diesen bevorzugten lichtempfindlichen Aufzeichnungsmaterialien wird durch die Menge an eingesetztem Photopolymerisationsinitiator sowie die Mengen der gegebenenfalls weiter enthaltenen Zusatzund/oder Hilfsstoffe bestimmt. Bevorzugt enthalten diese lichtempfindlichen Aufzeichnungsmaterialien nicht mehr als 99 Gew.%, insbesondere nicht mehr als 95 Gew.%, bezogen auf das lichtempfindliche Aufzeichnungsmaterial, an den erfindungsgemäßen vernetzbaren, oligomeren Harzen. Ethylenisch ungesättigte, photopolymerisierbare Monomere sind dabei in den bevorzugten erfindungsgemäßen lichtempfindlichen Aufzeichnungsmaterialien in Mengen von 0 bis 25 Gew.%, bezogen auf das lichtempfindliche Aufzeichnungsmaterial, enthalten, wobei der Anteil an diesen Monomeren, sofern sie mitverwendet werden, vorzugsweise mindestens 3 Gew.%, bezogen auf das lichtempfindliche Aufzeichnungsmaterial beträgt. Vorteilhafterweise sind in diesen bevorzugten erfindungsgemäßen lichtempfindlichen Aufzeichnungsmaterialien nicht polymerisierbare, die Belichtungs- und/

0188752

oder Polymerisationseigenschaften beeinflussende Hilfsstoffe in Mengen von 0,01 bis etwa 8 Gew.%, bezogen auf das lichtempfindliche Aufzeichnungsmaterial, enthalten. Sofern Zusatzstoffe, die die mechanischen Eigenschaften der Aufzeichnungsmaterialien verbessern und/oder modifizieren, insbesondere polymere Bindemittel, mitverwendet werden, liegt ihr Anteil vorzugsweise im Bereich von 1 bis 20 Gew.%, bezogen auf das lichtempfindliche Aufzeichnungsmaterial. Es ist jedoch ein besonderer Vorteil dieser bevorzugten, lichtempfindlichen Aufzeichnungsmaterialien, daß hierbei auf die Mitverwendung solcher zuletzt genannten Zusatzstoffe, insbesondere polymerer Bindemittel, verzichtet werden kann.

Die Herstellung der erfindungsgemäßen photopolymerisierbaren und vernetzbaren Zusammensetzungen bzw. Aufzeichnungsmaterialien kann in an sich bekannter und üblicher Weise durch homogenes Vermischen der einzelnen Bestandteile dieser Zusammensetzungen bzw. Aufzeichnungsmaterialien erfolgen. Das Mischen kann beispielsweise mechanisch in Knetern, Mischern, Extrudern oder dergleichen vorgenommen werden, oder vorteilhafter Weise in Lösung, indem man die Komponenten der photopolymerisierbaren und vernetzbaren Zusammensetzungen bzw. Aufzeichnungsmaterialien in einem geeigneten Lösungsmittel oder Lösungsmittel-Gemisch löst. Geeignete Lösungsmittel sind beispielsweise niedere Alkanole, Ketone oder Ester, wie z.B. Methanol, Aceton, Methylethylketon, Essigsäureethylester, oder Mischungen hiervon. Die lichtempfindlichen Aufzeichnungsmaterialien werden für ihre Verwendung, beispielsweise die Herstellung von bildmäßig strukturierten Schutz- oder Überzugsschichten sowie insbesondere auch zur Herstellung von Flachdruckplatten, im allgemeinen in Form einer dünnen lichtempfindlichen, photopolymerisierbaren und vernetzbaren Aufzeichnungsschicht auf einen geeigneten, dimensionsstabilen Träger aufgebracht.

Als dimensionsstabile Träger kommen hierbei die für lichtempfindliche Aufzeichnungsmaterialien an sich bekannten und üblichen, dimensionsstabilen, starren oder vorzugsweise flexiblen Schichtträger in Betracht, wobei die Art des Schichtträgers in bekannter Weise vom Verwendungszweck der lichtempfindlichen Aufzeichnungsmaterialien mitbestimmt wird. Beispiele für dimensionsstabile Träger sind unter anderem Kunststoff-Filme oder -Folien, z.B. Polyesterfolien, metallische Schichtträger, z.B. aus Magnesium, Zink, Kupfer oder Aluminium, sowie metallbeschichtete Substrate, beispielsweise metallisierte Kunststoff-Folien oder kupferkaschierte Basismaterialien. Bevorzugt kommen für die erfindungsgemäßen lichtempfindlichen Aufzeichnungsmaterialien Träger mit metallischer oder metalloxidischer Oberfläche in Betracht. Für die Herstellung von bildmäßig strukturierten Schutz- und Überzugsschichten kann das erfindungsgemäße lichtempfindliche, photopolymerisierbare und vernetzbare Aufzeichnungsmaterial direkt auf das zu schützende sowie gegebenenfalls dauerhaft zu modifizierende Substrat als Träger aufgebracht werden. Für die Herstellung von Flachdruckplatten werden vorzugsweise metallische Schichtträger, insbesondere Aluminiumbleche, eingesetzt, die vorteilhafterweise oberflächlich mechanisch, chemisch und/oder elektrochemisch vorbehandelt sind. Mit besonderem Vorteil werden für die Herstellung von Flachdruckplatten als Träger Aluminiumbleche verwendet, die für diesen Zweck in an sich bekannter Weise oberflächlich mechanisch, chemisch oder elektrochemisch aufgerauht und/ oder - nach einer gegebenenfalls vorgenommenen Aufrauhung - anodisch oxidiert worden sind. Eine weitere Nachbehandlung dieser aufgerauhten und/ oder anodisierten Aluminiumbleche, z.B. mit heißem Wasser oder Wasserdampf, Polyvinylphosphonsäure, Alkalisilikaten, Phosphaten, Hexafluorzirkonaten, Chromaten, Boraten, Polyacrylamiden oder Cellulosederivaten, kann vorteilhaft sein. Die dimensionsstabilen Träger für die lichtempfindlichen Aufzeichnungsmaterialien haben üblicherweise eine Dicke im Bereich von etwa 0,03 bis etwa 0,3 mm.

Die lichtempfindlichen, photopolymerisierbaren und vernetzbaren Aufzeichnungsmaterialien werden auf die dimensionsstabilen Träger vorteilhafterweise aus Lösung durch Gießen, Tauchen, Sprühen oder eine andere bekannte Auftragstechnik in der gewünschten Schichtstärke aufgebracht. Für Flachdruckplatten liegt die Trockenschichtdicke der auf den Träger aufgebrachten lichtempfindlichen Aufzeichnungsmaterialien im allgemeinen im Bereich von 0,5 bis 6 $\mu$m.

Da sich die erfindungsgemäßen lichtempfindlichen, photopolymerisierbaren und vernetzbaren Aufzeichnungsmaterialien durch eine vergleichsweise hohe Sauerstoffunempfindlichkeit auszeichnen, ist es ein besonderer Vorteil, daß auf eine separate Deck- und Sauerstoffsperrschicht auf der lichtempfindlichen, photopolymerisierbaren und vernetzbaren erfindungsgemäßen Aufzeichnungsschicht verzichtet werden kann. Jedoch ist es selbstverständlich auch möglich, eine solche Deckschicht auf der lichtempfindlichen, photopolymerisierbaren und vernetzbaren Aufzeichnungsschicht vorzusehen, wobei sich hierfür insbesondere Deckschichten aus Polyvinylalkohol oder Polyvinylalkohol-Derivaten als zweckmäßig und vorteilhaft erwiesen haben.

Zur bildmäßigen Strukturierung, beispielsweise der Herstellung von Flachdruckplatten, wird das schichtförmig auf den dimensionsstabilen Träger aufgebrachte erfindungsgemäße lichtempfindliche Aufzeichnungsmaterial zunächst bildmäßig mit aktinischem Licht belichtet. Diese bildmäßige Belichtung kann beispielsweise mit diffusem aktinischem Licht durch eine photographische Bildvorlage hindurch, beispielsweise durch ein photographisches Negativ oder Positiv, oder aber auch mit einem bildmäßig modulierten Lichtstrahl, beispielsweise einem bildmäßig modulierten Laserstrahl, erfolgen. Für die bildmäßige Belichtung der erfindungsgemäßen lichtempfindlichen Aufzeichnungsmaterialien eignen sich die üblichen Lichtquellen von aktinischem Licht, wie beispielsweise UV-Fluoreszenz-Röhren, Quecksilberhoch-, -mittel- oder -niederdruckstrahler, superaktinische Leuchtstoffröhren, Xenon-Impuls-Lampen, metallhalogenid-dotierte Lampen, Kohlebogenlampen etc., aber auch UV-Laser, Argonlaser und ähnliche. Die von den Lichtquellen emittierte Wellenlänge soll im allgemeinen zwischen 230 und 450 nm, bevorzugt zwischen 300 und 420 nm, liegen und insbesondere auf die Eigenabsorption des mitverwendeten Photoinitiators abgestimmt sein. Durch die bildmäßige Belichtung der erfindungsgemäßen lichtempfindlichen Aufzeichnungsmaterialien mit dem aktinischen Licht wird in den belichteten Bereichen der Aufzeichnungsschicht eine Photopolymerisation ausgelöst, die in diesen Bereichen zu einer Vernetzung und damit zu einer Löslichkeitsdifferenzierung zwischen den belichteten und unbelichteten Schichtbereichen führt. Nach der bildmäßigen Belichtung werden die unbelichteten, unvernetzten Schichtbereiche der lichtempfindlichen Aufzeichnungsmaterialien mit einer wäßrig-alkalischen Entwicklerlösung ausgewaschen und dadurch die Bildstruktur, beispielsweise der Flachdruckplatte, entwickelt. Das Entwickeln kann durch Sprühen, Waschen, Reiben, Bürsten etc., mit der Entwicklerlösung erfolgen. Als Entwicklerlösungen kommen dabei insbesondere wäßrig-alkalische Lösungen in Betracht, die zur Einstellung des günstigsten pH-Wertes, im allgemeinen im Bereich von 8 bis 14, vorzugsweise im Bereich von 9 bis 13, alkalisch reagierende Substanzen, wie z.B. Borax, Dinatriumhydrogenphosphat, Soda oder Alkalihydroxide oder organische Basen, wie Di- oder Triethanolamin, in Wasser gelöst enthalten. Als typische und vorteilhafte Entwicklerlösung sei eine 1 gew.%ige Lösung von Soda in Wasser genannt. Die wäßrig-alkalischen Entwicklerlösungen können auch Puffersalze, z.B. wasserlösliche Alkaliphosphate, -silikate, -borate, -acetate oder -benzoate, enthalten. Als weitere Bestandteile der Entwicklerlösungen können Netzmittel, vorzugsweise anionische Netzmittel, und gegebenenfalls lösliche Polymere, wie z.B. Natriumcarboximethylcellulose, Polyvinylalkohol, Polynatriumacrylat und dergleichen, mitverwendet werden. Obwohl die erfindungsgemäßen lichtempfindlichen Aufzeichnungsmaterialien mit rein wäßrig-alkalischen Entwicklerlösungen ausgewaschen werden können, ist es doch auch möglich, daß die wäßrig-alkalischen Entwicklerlösungen kleine Mengen eines organischen Lösungsmittels, wie z.B. eines niederen Alkanols, Aceton oder Tetrahydrofuran, zugesetzt enthalten.

Bei der Herstellung von Flachdruckplatten wird diese im allgemeinen nach der Entwicklung von der noch anhaftenden Entwicklerlösung befreit und, gegebenenfalls bei Temperaturen bis zu 120°C, getrocknet. In manchen Fällen ist es zweckmäßig, die so erhaltene Flachdruckplatte anschließend nochmals vollflächig mit aktinischem Licht nachzubelichten, um ihre Festigkeit zu erhöhen. Auch kann die so erhaltene Flachdruckplatte in an sich bekannter und üblicher Weise nachbehandelt und für den Offset-Druck noch weiter vorbereitet werden, z.B. durch eine Hydrophilierung oder Gummierung der wasserführenden Oberfläche oder durch eine Konservierung der Flachdruckplatte bis zum Drucken, wenn zwischen der Herstellung der Flachdruckplatte und dem Einsatz in der Druckmaschine eine längere Lagerzeit gegeben ist.

Die erfindungsgemäßen lichtempfindlichen, photopolymerisierbaren Zusammensetzungen bzw. Aufzeichnungsmaterialien mit den erfindungsgemäßen speziellen, vernetzbaren, oligomeren Harzen besitzen neben einer guten Haftung zu metallischen Trägern, und zwar sowohl im unbelichteten als auch im belichteten Zustand, insbesondere gute Belichtungseigenschaften, eine hohe Photoreaktivität und zeigen nach der bildmäßigen Belichtung ein gutes Auswaschverhalten in wäßrig-alkalischen Entwicklerlösungen ohne Überwaschempfindlichkeit. Trotz kurzer Belichtungs- und Entwicklungszeiten wird mit den erfindungsgemäßen, lichtempfindlichen Aufzeichnungsmaterialien eine sehr gute Differenzierung zwischen belichteten und unbelichteten Bereichen erzielt, so daß nicht nur eine exakte Bildreproduktion, sondern auch - mitbedingt durch das hohe Auflösungsvermögen - die Wiedergabe feiner und feinster Bildelemente exakt und korrekt möglich ist. Zu erwähnen ist insbesondere auch die hohe mechanische und chemische Beständigkeit der mit den erfindungsgemäßen lichtempfindlichen Aufzeichnungsmaterialien hergestellten Schichten und Flachdruckplatten, insbesondere gegenüber wäßrigen und organischen Lösungsmitteln oder auch anderen Chemikalien, mit denen sie bei ihrer Verarbeitung - Flachdruckplatten sowohl in als auch außerhalb der Druckmaschine - in Berührung kommen. Erfindungsgemäß lassen sich so Flachdruckplatten mit hoher Qualität und exakter Bild- und Tonwertwiedergabe auch bei feinen und feinsten Bildelementen und hohen Druckauflagen herstellen.

Die Erfindung wird durch die nachfolgenden Beispiele näher erläutert. Die in den Beispielen genannten Teile und Prozente beziehen sich, sofern nicht anders angegeben, auf das Gewicht.

Beispiel 1

Durch Umsetzung des Diglycidylethers aus Bisphenol A und Epichlorhydrin mit Adipinsäure und Acrylsäure im Molverhältnis 2:1:2 wurde ein hydroxylgruppenhaltiges Harz mit einem OH-Äquivalentgewicht von 270 hergestellt.

Zu 386 Teilen dieses Harzes (70 %ig in Ethylacetat) wurden 148 Teile Phthalsäureanhydrid (1 Äquivalent), 2,5 Teile Dimethylaminopyridin, 1 Teil Di-tert.-butyl-p-kresol und 84 Teile Ethylactat zugesetzt. Anschließend wurde die Reaktionsmischung auf 80°C aufgeheizt und 5 Stunden bei dieser Temperatur gehalten. Danach wurden in einer zweiten Reaktionsstufe dem erhaltenen Reaktionsprodukt 40 Teile Pentaerythrittriglycidylether und 2,5 Teile Dimethylaminopyridin zugesetzt. Anschließend wurde die Reaktionsmischung für weitere 5 Stunden bei 80°C gehalten. Danach wurde mit 259 Teilen Ethylacetat verdünnt und auf Raumtemperatur abgekühlt.

Der Feststoffgehalt der auf diese Weise hergestellten Harzlösung betrug 46 %. Für das vernetzbare, Acryloyl-Gruppen und freie Carboxyl-Gruppen enthaltende oligomere Harz wurde eine Säurezahl von 119 mg KOH/g ermittelt.

Beispiel 2

500 Teile des in Beispiel 1 verwendeten hydroxylgruppenhaltigen Ausgangsharzes wurden mit 172,6 Teilen Phthalsäureanhydrid, 1,3 Teilen Di-tert.-butyl-p-kresol, 3,2 Teilen Dimethylaminopyridin und 74 Teilen Ethylacetat gemischt. Dieses Reaktionsgemisch wurde auf 77°C aufgeheizt und 4 Stunden bei dieser Temperatur gehalten. Anschließend wurden zu der Reaktionslösung 81,2 Teile des aus Bisphenol A und Epichlorhydrin hergestellten Diglycidylethers und 2,85 Teile Dimethylaminopyridin, gelöst in 120 Teilen Ethylacetat, zugegeben. Diese Mischung wurde in der zweiten Reaktionsstufe 5 Stunden bei 77°C gehalten und anschließend mit 260 Teilen Ethylacetat verdünnt und auf Raumtemperatur abgekühlt.

Der Feststoffgehalt der auf diese Weise erhaltenen Harzlösung betrug 49,6 %. Für das Acryloyl-Gruppen und freie Carboxylgruppen enthaltende oligomere Harz wurde eine Säurezahl von 97 mg KOH/g gemessen.

Beispiel 3

143,1 Teilen der gemäß Beispiel 2 hergestellten oligomeren Harz-Lösung, 20 Teile Trimethylolpropantriacrylat, 6 Teile Benzophenon, 2 Teile Michlers Keton und 1 Teil Viktoriareinblau B (C.I. 44045) wurden in 1839,5 Teilen Tetrahydrofuran gelöst. Diese Lösung wurde so auf ein elektrochemisch aufgerauhtes und anodisch oxidiertes Aluminiumblech für Offset-Platten aufgebracht, daß nach dem Verdampfen des Lösungsmittels und Trocknen der Schicht (2 min bei 80°C) eine Trockenschichtdicke von etwa $2\mu m$ (Schichtgewicht: 2 g/m$^2$) resultierte.

Das so hergestellte lichtempfindliche Aufzeichnungselement wurde in einem Offset-typischen Belichter 12 Sekunden lang durch eine photographische Negativvorlage bildmäßig mit aktinischem Licht belichtet und anschließend mit einer wäßrig-alkalischen Lösung mit einem pH-Wert im Bereich von 11 bis 12 ausgewaschen. Die resultierende Flachdruckplatte zeigte eine hervorragende Auflösung. Sowohl negative als auch positive Linien von $6\mu m$ Breite waren einwandfrei reproduziert. Die Platte lieferte auch nach über 25.000 Drucken äußerst exakte Bild- und Tonwert-Wiedergaben.

## Patentansprüche

1. Vernetzbares, in wäßrig-alkalischen Lösungen lösliches oder zumindest dispergierbares Acryloyl- und/oder Methacryloyl-Gruppen sowie freie Carboxyl-Gruppen enthaltendes, oligomeres Harz mit einem mittleren Molekulargewicht (Zahlenmittel) im Bereich von etwa 1000 bis 10.000 und einer Säurezahl im Bereich von 50 bis 150, wie es erhältlich ist durch Umsetzung einer eine oder mehrere (Meth)acryloyl-Gruppen enthaltenden Diol- oder Polyolverbindung mit mehrfunktionellen Carbonsäuren oder deren Derivaten unter Ausbildung von sauren Teilestern der Carbonsäuren bzw. der Carbonsäurederivate und anschließende kettenverlängernde Umsetzung eines Teils der freien Carboxylgruppen des so erhaltenen Reaktionsproduktes mit einem Di- und/oder Polyepoxid.

2. Vernetzbares, oligomeres Harz gemäß Anspruch 1, dadurch gekennzeichnet, daß das oligomere Harz im Mittel etwa 2,1 bis 8 acrylische und/oder methacrylische Doppelbindungen pro Molekül enthält.

3. Vernetzbares, oligomeres Harz nach einem der Ansprüche 1 oder 2, dadurch gekennzeichnet, daß die Säurezahl des oligomeren Harzes im Bereich von 60 bis 120 liegt.

4. Vernetzbares, oligomeres Harz gemäß einem der Ansprüche 1 bis 3, dadurch gekennzeichnet, daß das oligomere Harz ein mittleres Molekulargewicht (Zahlenmittel) im Bereich von etwa 1500 bis 6000 aufweist.

5. Vernetzbares, oligomeres Harz nach einem der Ansprüche 1 bis 4, dadurch gekennzeichnet, daß es sich bei der (Meth)acryloyl-Gruppen enthaltenden Diol- oder Polyol-Verbindung um das Umsetzungsprodukt eines aliphatischen, cycloaliphatischen oder vorzugsweise aromatischen Di- oder Polyepoxides mit einer äquivalenten Menge an Acrylsäure und/oder Methacrylsäure handelt.

6. Vernetzbares, oligomeres Harz nach einem der Ansprüche 1 bis 5, dadurch gekennzeichnet, daß es sich bei den mehrfachen Carbonsäuren bzw. deren Derivaten um, vorzugsweise aromatische, Dicarbonsäuren oder cyclische Carbonsäureanhydride handelt.

7. Vernetzbares, oligomeres Harz nach einem der Ansprüche 1 bis 6, dadurch gekennzeichnet, daß für die Umsetzung der freien Carboxyl-Gruppen des intermediär erhaltenen Reaktionsprodukts eine aliphatische oder aromatische Di- und/oder Triglycidylverbindung verwendet wird.

8. Vernetzbares, oligomeres Harz nach einem der Ansprüche 1 bis 7, dadurch gekennzeichnet, daß bei seiner Herstellung praktisch alle Hydroxylgruppen der die (Meth)acryloyl-Gruppen enthaltenden Diol- oder Polyolverbindung mit den mehrfunktionellen Carbonsäuren oder deren Derivaten umgesetzt werden, und die freien Carboxylgruppen des so erhaltenen Reaktionsproduktes mit dem Di- und/oder Polyepoxid in einem Äquivalentverhältnis COOH-Gruppen : Glycidyl-Gruppen von 1:0,8 bis 1:0,2 umgesetzt werden.

9. Lichtempfindliches, photopolymerisierbares und vernetzbares Aufzeichnungsmaterial aus einer homogenen, in wäßrig-alkalischen Lösungen löslichen oder zumindest dispergierbaren Mischung, enthaltend mindestens einen Photopolymerisationsinitiator sowie mindestens eine ethylenisch ungesättigte, photopolymerisierbare Verbindung sowie gegebenenfalls weitere Zusatz- und/oder Hilfsstoffe, dadurch gekennzeichnet, daß in dieser Mischung als photopolymerisierbare Komponente mindestens ein vernetzbares oligomeres Harz gemäß einem der Ansprüche 1 bis 8 enthalten ist.

10. Lichtempfindliches Aufzeichnungsmaterial gemäß Anspruch 9, dadurch gekennzeichnet, daß es aus einer homogenen Mischung von mindestens 60 Gew.%, bezogen auf das lichtempfindliche Aufzeichnungsmaterial, mindestens eines vernetzbaren, oligomeren Harzes gemäß einem der Ansprüche 1 bis 8, 0,001 bis 10 Gew.%, bezogen auf das lichtempfindliche Aufzeichnungsmaterial, mindestens eines Photopolymerisationsinitiators sowie 0 bis 39,9 Gew.%, bezogen auf das lichtempfindliche Aufzeichnungsmaterial an weiteren photopolymerisierbaren und/oder nicht photopolymerisierbaren Zusatz- und/oder Hilfsstoffen besteht.

11. Verfahren zur Herstellung einer Flachdruckplatte, bei dem ein lichtempfindliches Aufzeichnungselement mit einem für Flachdruckplatten typischen Träger mit hydrophiler Oberfläche und einer darauf aufgebrachten, etwa 0,5 bis 6 $\mu$m dicken, photopolymerisierbaren Aufzeichnungsschicht bildmäßig mit aktinischem Licht belichtet wird und anschließend die nicht belichteten Bereiche der Aufzeichnungsschicht mittels einer wäßrig-alkalischen Entwicklerlösung entfernt werden,